# EUROPÄISCHE PATENTSCHRIFT

(11) **EP 0 338 337 B1**
(45) Veröffentlichungstag und Bekanntmachung des Hinweises auf die Patenterteilung: **13.07.1994**
(21) Anmeldenummer: 89106086.5
(22) Anmeldetag: 06.04.1989
(51) Int. Cl.: H01L 21/00, H01L 21/68

(54) **Verschliessbarer Behälter zum Transport und zur Lagerung von Halbleiterscheiben**
Closable container for the transport and the storage of semi-conductor wafers
Récipient susceptible d'être fermé pour le transport et le stockage de plaquettes semi-conductrices

(30) Priorität: 22.04.1988 DE 3813674
(43) Veröffentlichungstag der Anmeldung: 25.10.1989
(73) Patentinhaber: SIEMENS AKTIENGESELLSCHAFT, 80333 München (DE)
(72) Erfinder: Grohrock, Peter, D-8011 Höhenkirchen-Siegertsbrunn (DE)

(56) Entgegenhaltungen:
- EP-A- 0 151 336
- EP-A- 0 273 226
- WO-A-86/00870
- WO-A-87/04043
- BE-A- 688 450
- US-A- 4 582 219

## Beschreibung

Die Erfindung betrifft einen verschließbaren Behälter zum Transport und zur Lagerung von Halbleiterscheiben, die sich in einer in dem Behälter angeordneten Bearbeitungskassette befinden, mit einer Bodenplatte, einer Haube und mindestens zwei Verschlußhebeln zum kraftschlüssigen Schließen der Haube mit der Bodenplatte.

In der Halbleiterfertigung werden Halbleiterscheiben unter Reinraumbedingungen hergestellt und weiterbearbeitet. Zur Lagerung der Halbleiterscheiben und zum Transport der Halbleiterscheiben zu den verschiedenen Bearbeitungsstätten sind daher Behälter notwendig, deren Innenraum ein Reinraumklima bereitstellt. Dazu müssen die Behälter möglichst dicht sein und dürfen selbst keine kontaminierenden Stoffe, z.B. Materialausgasungen, freigeben.

Standardisierungsvorschriften für Transportbehälter, wie sie in der Veröffentlichung des Documents No. 1332 von Semiconductor Equipment and Materials Institute vom 10.01.1986 angegeben sind, dienen dazu, Behälter zu charakterisieren, die austauschbar sind, standardisierte Maße für die Roboterhandhabung aufweisen und zur Aufnahme von standardisierten Verarbeitungskassetten geeignet sind. Außerdem werden in dieser Veröffentlichung Empfehlungen über die Anforderungen gegeben, die die Bestandteile eines Transportbehälters erfüllen sollen. Die empfohlenen Standardisierungen sind unter dem Begriff "Standard Mechanical Interface for Wafer Cassette Transfer" Standard (SMIF-Standard) zusammengefaßt.

Ein Behälter gemäß dem Oberbegriff, der dem SMIF-Standard entspricht, ist aus der US-PS 4,582,219 bekannt. Dieser Behälter weist einen an der Innenwand der Haube befestigten starren Halbleiterscheibenhalter auf, der im geschlossenen Zustand des Behälters die in der Bearbeitungskassette befindlichen Halbleiterscheiben berührt. Der Halbleiterscheibenhalter ist außerdem bei geschlossenem Behälter durch einen an der Bodenplatte befindlichen Riegel gehalten. Ein Nachteil dieses Behälters besteht deshalb darin, daß er Bestandteile aufweist, die so gestaltet sind, daß sie beim Öffnen und Schließen des Behälters und beim Transport Reibung verursachen, wobei kontaminierende Rartikel freigesetzt werden können. Außerdem weist der Behälter kein Dichtungselement zwischen Bodenplatte und Haube auf, das die Partikeldichtheit des Behälters sichert. Beim Verschließen des Behälters wird lediglich der hervorstehende Rand der Bodenplatte durch die Federkraft der Verschlußhebel gegen den Rand der Haube gedrückt.

In der älteren europäischen Patentanmeldung EP-A-0 273 226 (87117836.4) ist außerdem ein Transportbehälter zum Transport und zur Lagerung von in einer Halbleiterscheibenkassette befindlichen Halbleiterscheiben vorgeschlagen worden. Dieser Transportbehälter ist zwar staubdicht verschließbar und weist einen reibungsfreien Halbleiterscheibenhalter auf, hat aber eine aufwendige komplexe Ausstattung mit einem austauschbaren, zweiteiligen Innenbehälter.

Transportbehälter für Halbleiterscheiben, die gleichzeitig partikeldicht sind, kontaminationsfrei sind, dem SMIF-Standard genügen und sich durch einen einfachen Aufbau auszeichnen, sind bisher nicht bekannt.

Aufgabe der Erfindung ist es daher, einen Behälter zum Transport und zur Lagerung von in einer Bearbeitungskassette befindlichen Halbleiterscheiben anzugeben, der die Halbleiterscheiben vor Kontaminationen durch die Umgebung schützt, beim Transport und beim Be- und Entladen keine die Halbleiterscheiben kontaminierenden Partikel freisetzt und einen einfachen Aufbau aufweist. Der Behälter soll außerdem auch entsprechend den Vorschriften des SMIF-Standards gestaltbar sein.

Diese Aufgabe wird bei einem Behälter der eingangs genannten Art dadurch gelöst, daß
a) ein Dichtungselement zum luftdichten Abschluß des Behälters umlaufend zwischen der Haube und der Bodenplatte vorgesehen ist und
b) eine durch Filmgelenke aus dünnen Materialstreifen bewegliche Halbleiterscheibensicherung, die an der Innenwand der Haube befestigt ist und über eine Führungsplatte so mit der Bodenplatte in Kontakt steht, daß sie beim Schließen des Behälters durch die Bodenplatte in Sicherungsposition bewegt wird in der die Halbleiterscheibensicherung die Halbleiterscheiben nicht berührt.

Weitere Ausgestaltungen und Weiterbildungen der Erfindung gehen aus den Unteransprüchen sowie der nachfolgend anhand von Ausführungsbeispielen gegebenen Beschreibung hervor.

Zu den im folgenden beschriebenen Ausführungsbeispielen werden acht FIG betrachtet, die als schematische Darstellungen ausgeführt sind.
- FIG 1: zeigt einen geschlossenen Behälter als dreidimensionale Darstellung,
- FIG 2: zeigt die Haube des Behälters aus FIG 1 und eine Bodenplatte als Schnittdarstellungen mit der in FIG 1 eingezeichneten Schnittlinie II-II,
- FIG 3: zeigt einen Verschlußhebel zum Schließen der Haube und der Bodenplatte aus FIG 2 als dreidimensionale Darstellung,
- FIG 4: zeigt einen Ausschnitt eines Schnittes des geschlossenen Behälters aus FIG 1 mit der Bodenplatte aus FIG 2 entlang der in FIG 1 eingezeichneten Schnittline IV-IV,
- FIG 5: zeigt die Halbleiterscheibensicherung aus FIG 2 als dreidimensionale Darstellung,
- FIG 6: zeigt einen Schnitt des in FIG 2 dargestellten Dichtungselements mit Dichtlippe bei fast geschlossenem Behälter,
- FIG 7: zeigt einen Schnitt eines Dichtungselements mit Dichtlippe mit einer anderen Ausgestaltung der Bodenplatte
- FIG 8: zeigt einen Schnitt eines Dichtungselementes mit elastisch deformierbarem Dichtungsring bei geöffnetem Behälter,
- FIG 9: zeigt das Dichtungselement aus FIG 7 bei geschlossenem Behälter.

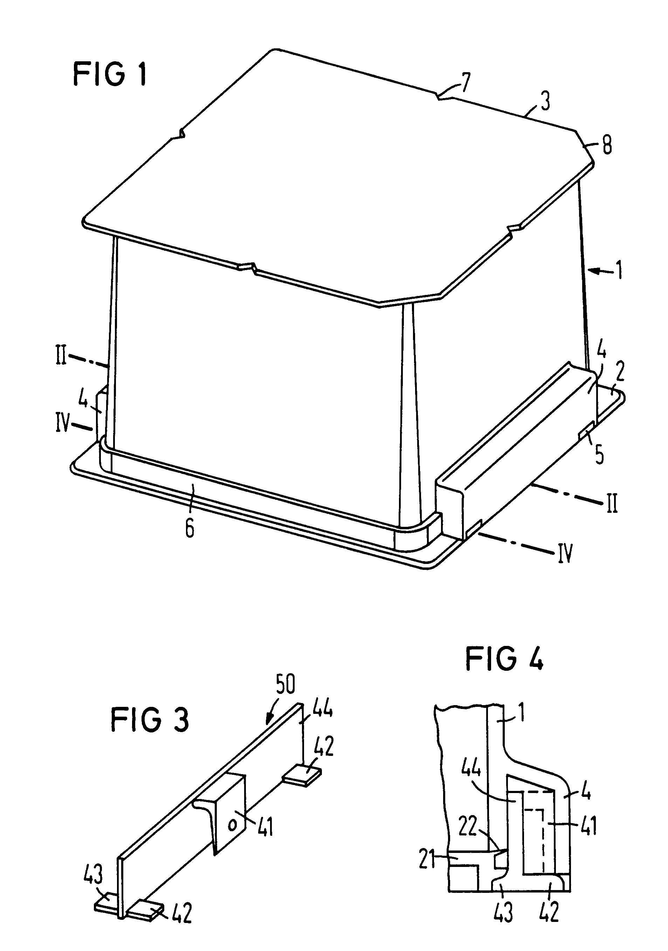

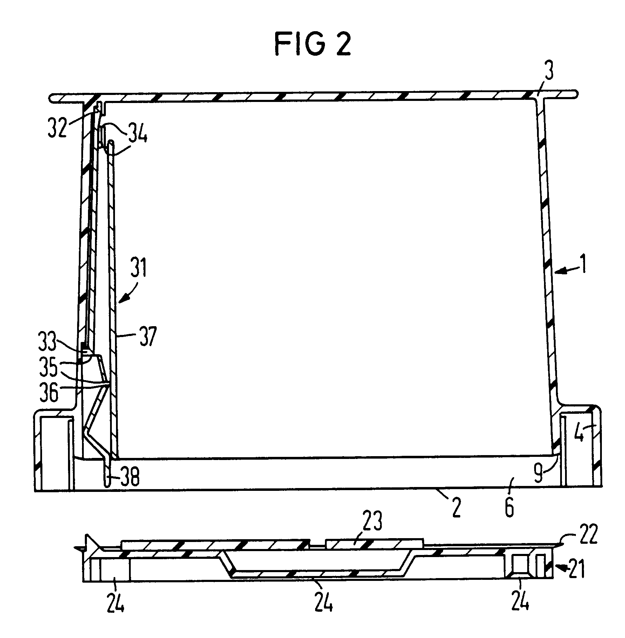

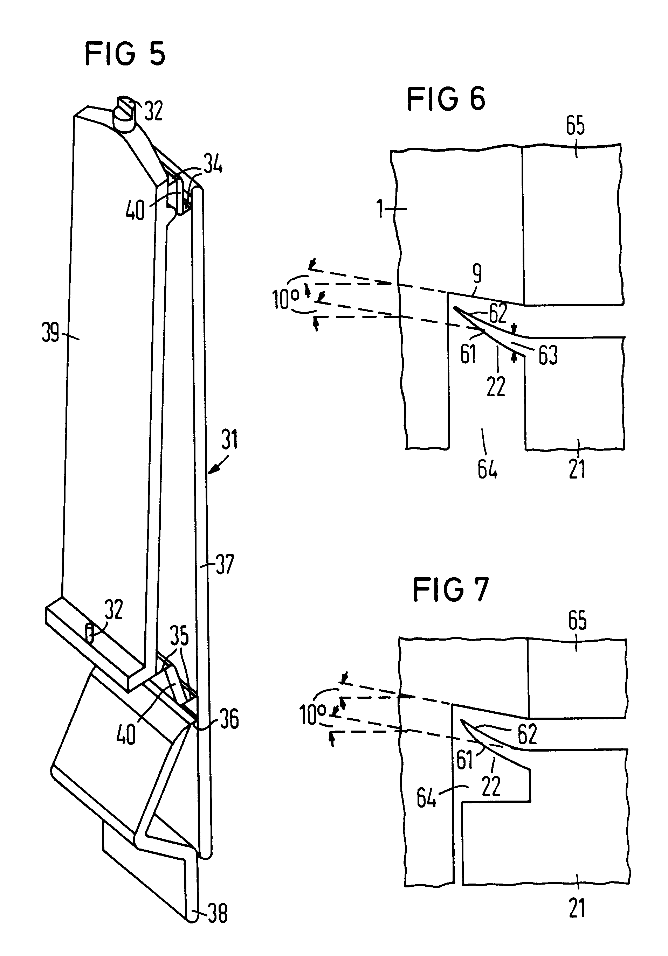

FIG 1: Die Abmessungen des Behälters sind so gewählt, daß sie dem SMIF-Standard genügen. Dazu ist die Haube 1 so geformt, daß die Bodenplatte bei geschlossenem Behälter im unteren Randbereich 6 der Haube versenkt angeordnet ist. Die auf gegenüberliegenden Seiten der Haube 1 vorgesehenen Ausformungen 4 dienen zur Aufnahme der Verschlußhebel 50 (siehe FIG 3 und FIG 4), wobei Ausnehmungen 5 zur Arretierung der Riegel vorgesehen sind. Der hervorstehende obere Haubenrand 3, der Einkerbungen 7 und zum Teil abgerundete Ecken 8 aufweist und der hervorstehende untere Haubenrand 2 sind für die Handhabung des Behälters mittels Roboter gestaltet. Die Linien II-II und IV-IV verweisen auf entsprechende Schnittdarstellungen der FIG 2 und 4.

FIG 2: Die Abmessungen der Bodenplatte 21 sind so auf die der Haube 1 abgestimmt, daß beim Schließen des Behälters die Bodenplatte 21 im unteren Randbereich 6 der Haube 1 versenkt ist. Die Erhebungen 23 auf der Oberseite der Bodenplatte 21 dienen zur Arretierung einer auf der Bodenplatte 21 stehenden, mit Halbleiterscheiben gefüllten Bearbeitungskassette (nicht in der FIG dargestellt) und sind auf die Abmessungen der verwendeten Bearbeitungskassette abgestimmt. Beim automatischen Öffnen des Behälters kann die Bodenplatte 21 die Funktion einer Tür wahrnehmen, die nach Lösen der Verschlußhebel 50 (siehe FIG 3 und FIG 4) aus der am vorspringenden unteren Rand 2 festgehaltenen Haube 1 mitsamt der auf ihr stehenden Bearbeitungskassette senkrecht nach unten herausgezogen wird. Auf der Unterseite der Bodenplatte 21 sind verschiedene Ausformungen 24 vorgesehen, die zur maschinellen Handhabung beim Öffnen und Schließen des Behälters ausgestaltet sind. Die Bodenplatte 21 weist eine umlaufende, über den Rand der Bodenplatte 21 hervorstehende und fest mit dieser verbundenen Dichtlippe 22 auf, die aus dem gleichen Material besteht, aus dem die Bodenplatte 21 hergestellt ist. Die Form der Dichtlippe 22 und die Dichtfläche 9 der Haube 1 sind so gestaltet, daß bei geschlossenem Behälter die Flächenpressusng über die Fläche der Dichtlippe konstant ist. Dadurch wird eine optimale Dichtigkeit und aufgrund des geringen Verschleißes eine lange Lebensdauer des Dichtungselements erreicht.

Die Halbleiterscheibensicherung 31 ist für in einer Bearbeitungskassette vertikal übereinander angeordnete Halbleiterscheiben (nicht in der Figur dargestellt) vorgesehen.

Die Halbleiterscheibensicherung 31 ist durch zwei Noppen-Vertiefungs-Verbindungen 32, 33 austauschbar an der Innenwand der Haube 1 angebracht. Die Halbleiterscheibensicherung 31 weist eine durch Filmgelenke 34,35,36 beweglich aufgehängte Sicherungsplatte 37 auf, die durch eine beim Schließen des Behälters mit der Bodenplatte 21 in Kontakt stehende Führungsplatte 38 in Position gebracht wird. Das Bewegen der Halbleiterscheibensicherung 31 erfolgt beim Öffnen und Schließen des Behälters ohne das Auftreten gleitender Reibung, bei der die Halbleiterscheiben kontaminierende Partikel freigesetzt werden könnten. Die Abmessungen der Halbleiterscheibensicherung 31 und die Positionierung der Bearbeitungskassette ist so gewählt, daß die Halbleiterscheibensicherung 31 im geschlossenen Zustand des Behälters die Halbleiterscheiben nicht berührt. Der Abstand zwischen der Sicherungsplatte 37 der Halbleiterscheibensicherung 31 zu den Halbleiterscheiben bei geschlossenem Behälter kann z.B. 0,1 mm bis 1 mm sein, beim Be-und Entladen z.B. ca. 3 mm. Die Halbleiterscheibensicherung 31 soll die Halbleiterscheiben im Normalfall nicht berühren, jedoch deren Bewegungsspielraum bei auftretenden erhöhten horizontalen Beschleunigungen in Grenzen halten.

Da die Materialien, aus denen die Behälterbestandteile hergestellt sind, möglichst wenig kontaminierende Partikel freisetzen dürfen, ist es zweckmäßig, alle Behälterbestandteile aus ausgasungsfreien Kunststoffen herzustellen. Zur Vermeidung statischer Aufladungen, die elektronische Bauelemente und Schaltungen beschädigen können, ist es vorteilhaft, den Innenbereich des Behälters aus antistatischem Material herzustellen. Kunststoffen, die diesen Anforderungen gerecht werden, sind mit Kohlenstoff versetztes Polypropylen und Polykarbonat. Ein weiterer Vorteil der Verwendung von Kunststoffmaterialien ist die Möglichkeit, eingefärbte oder durchsichtige Teile herzustellen. z.B. kann die Haube 1 des Behälters aus durchsichtigem, UV-undurchlässigem Kunststoff hergestellt sein, wodurch das mit dem Risiko Kontaminationen zu erzeugen verbundene Öffnen des Behälters zur Kontrolle seines Inhalts überflüssig wird. Durch die Verwendung reiner Kunststoffmaterialien werden Metallkontaminationen der Halbleiterscheiben vermieden. Auch die Abriebfestigkeit der Kunststoffmaterialien ist, insbesondere für die Halbleiterscheibensicherung, wichtig. Zur Herstellung der Halbleiterscheibensicherung, die dünne Materialstreifen als Filmgelenke aufweist, ist z.B. Polyäthylen sehr gut geeignet.

FIG 3, FIG 4: Der Verschlußhebel (50) weist zwei hervorstehende Kanten 42 auf, die in die Aussparungen 5 der Haube 1 beim Schließen des Behälters einrasten. Auf der gegenüberliegenden Seite des Verschlußhebels sind hervorstehende Kanten 43 vorgesehen, die in entsprechende Aussparungen der Bodenplatte 21 greifen. Sowohl der Hebelarm 41 als auch der Hebelsteg 44 sind federnde Elemente.

FIG 5: Die Halbleiterscheibensicherung 31 weist eine Befestigungsplatte 39 auf, die durch Noppen 32 an zwei Positionen an der Innenwand der Haube 1 des Behälters austauschbar befestigt werden kann. Die Sicherungsplatte 37 ist über zwei Gelenkplatten 40, die jeweils zwei Filmgelenke 34,35 aufweisen, an der Befestigungsplatte 39 beweglich angebracht. Die Führungsplatte 38, die durch ein Filmgelenk 36 an der Sicherungsplatte 37 befestigt ist, ist so geformt, daß sie die beim Schließen des Behälters auftretende vertikale Bewegung der Bodenplatte 21 in eine horizontale Bewegung der Sicherungsplatte 37 überträgt. Durch diese neuartige Konstruktion der Halbleiterscheibensicherung Im Behälter werden beim Be- und Entladen des Behälters mit Halbleiterscheiben keine zusätzlichen Partikel freigesetzt. Die Filmgelenke weisen zur optimalen Funktionsfähigkeit eine Dicke von kleiner als 0,2 mm auf.

FIG 6: Die Dichtlippe 22 ist mit der Bodenplatte 21 fest verbunden. Durch allgemein bekannte Kunststoffbearbeitungsverfahren ist es möglich, die Bodenplatte 21 mit der Dichtlippe 22 in einem Stück, z.B. aus Polypropylen oder Polykarbonat, herzustellen. Die Dichtlippe 22 ist so geformt, daß bei geschlossenem Behälter die Flächenpressung über die Fläche der Dichtlippe konstant ist. Dies kann dadurch erreicht werden, daß die in Richtung der Andruckkraft gemessene Dicke 63 der Dichtlippe 22 sich parabelförmig nach außen hin verjüngt, wobei die obere Außenfläche 61 und die untere Außenfläche 62 der Dichtlippe 22 unterschiedliche Krümmungen aufweisen. Da die Dichtfläche 9 der Haube 1 zum Innenraum 65 des Behälters hin mit einem Winkel von ca. 10° gegen die Horizontale abfallend ist und die Dichtlippe 22 über den oberen Rand der Bodenplatte 21 mit einem Winkel von größer als 10° hinausragt, wird beim Anpressen der Dichtlippe 22 gegen die Dichtfläche 9 ein Umschnappen der Dichtlippe 22 vermieden.

FIG 7: Die Erfindung beinhaltet auch eine Bodenplatte 21, die unterhalb der hervorstehenden Dichtlippe 22 verbreitert ausgeformt ist, so daß der unter der Dichtlippe 22 gebildete Schacht 64 verkleinert ist.

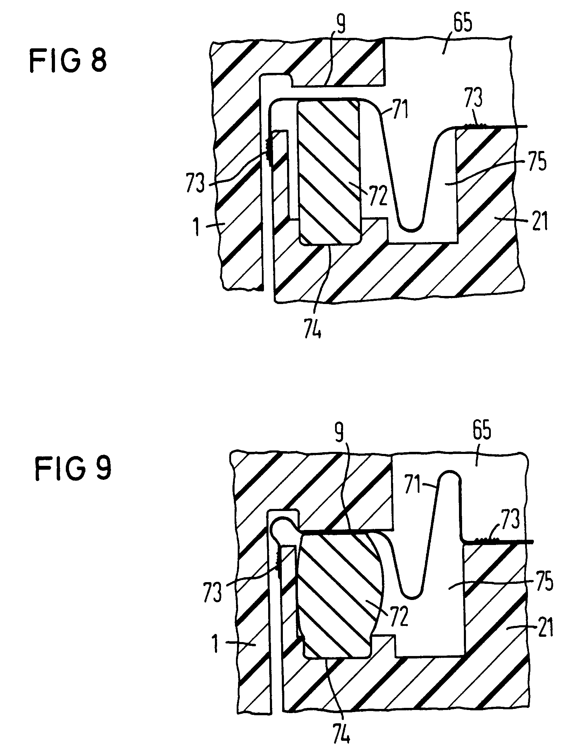

FIG 8: In einer weiteren Ausgestaltung der Erfindung ist vorgesehen, als Dichtungselement einen elastisch deformierbaren Dichtungsring 72 zwischen der Dichtfläche 9 der Haube 1 und der Bodenplatte 21 anzuordnen, der mit einem Streifen flexibler, abriebarmer Folie 71, z.B. aus Kunststoff, bedeckt ist. Die Kunststoff-Folie 71 schützt dabei den Innenraum 65 des Behälters vor Verunreinigungen durch von dem Dichtungsring 72 abgegebene Stoffe. Der Dichtungsring 72 kann dabei in einer in der Bodenplatte 21 vorgesehenen Nut 74 geführt sein, die Kunststoff-Folie auf der Oberfläche und dem Außenrand der Bodenplatte 21 durch Kunststoff-Schweißverbindungen 73 befestigt sein. Weitere Vorteile bietet eine Anordnung, bei der die Kunststoff-Folie 71 einen hermetisch abgeschlossenen luftgefüllten Hohlraum 75 mit der Bodenplatte 21 und dem Dichtungsring 72 bildet und dabei nicht gespannt ist. Eine solche Anordnung erfährt beim Schließen des Behälters eine Erhöhung des Druckes im Hohlraum 75, die beim Druckausgleich über die biegsame Kunststoff-Folie 71 mit dem Innenraum 65 des Behälters der Innendruck des Behälters erhöht wird. Der Innendruck des Behälters kann dadurch um ca. 1015 Pa (10 mbar) erhöht werden.

FIG 9: Bei geschlossenem Behälter ist der Dichtungsring 72 zusammengedrückt und die Kunststoff-Folie 71 durch den Überdruck im Hohlraum 75 zum Teil in den Innenraum 65 des Behälters gestülpt. In diesem Zustand ist ein Druckausgleich zwischen dem Hohlraum 75 und dem Innenraum 65 des Behälters hergestellt. Der Dichtungsring kann ein eingeschäumtes Kunststoffteil sein. Die Kompressionseigenschaften sind bei einer Shorehäre von ca. 5° optimal. Eine Polyäthylenfolie mit einer Dicke von ca. 0,2mm genügt den Anforderungen an die Folie sehr gut.

Der verschließbare Behälter zum Transport und zur Lagerung von Halbleiterscheiben weist gemäß der Lehre der Erfindung einen einfachen, kostengünstigen Aufbau auf. Er ist für die in der Halbleiterindustrie üblichen maschinellen Reinigungsverfahren geeignet und während der gesamten Lebensdauer wartungsfrei. Durch das umlaufend zwischen der Haube 1 und der Bodenplatte 21 vorgesehene Dichtungselement kann ein luftdichter Abschluß des Innenraums 65 des Behälters erreicht werden, so daß die im Behälter befindlichen Halbleiterscheiben vor Kontaminationen durch die Umgebung geschützt sind. Durch das Konzept der durch Filmgelenke beweglichen, austauschbaren Halbleiterscheibensicherung wird die Freisetzung kontaminierender Partikel beim Transport vermieden.

## Patentansprüche

1. Verschließbarer Behälter zum Transport und zur Lagerung von Halbleiterscheiben, die sich in einer in dem Behälter angeordneten Bearbeitungskassette befinden, mit einer Bodenplatte, einer Haube und mindestens zwei Verschlußhebeln zum kraftschlüssigen Schließen der Haube mit der Bodenplatte, **gekennzeichnet durch**
a) ein Dichtungselement (22, 72) zum luftdichten Abschluß des Behälters, das umlaufend zwischen der Haube (1) und der Bodenplatte (21) vorgesehen ist und
b) eine durch Filmgelenke (34,35,36) aus dünnen Materialstreifen bewegliche Halbleiterscheibensicherung (31), die an der Innenwand der Haube (1) befestigt ist und über eine Führungsplatte (38) so mit der Bodenplatte (21) in Kontakt steht, daß sie beim Schließen des Behälters durch die Bodenplatte (21) in eine vorgegebene Sicherungsposition bewegt wird, in der die Halbleiterscheibensicherung die Halbleiterscheiben nicht berührt.

2. Behälter nach Anspruch 1, **dadurch gekennzeichnet,** daß das Dichtungselement eine mit der Bodenplatte (21) fest verbundene flächendichtende Dichtlippe (22) ist und die Haube (1) eine nach innen abfallende Dichtfläche (9) aufweist, wobei die Dichtlippe (22) so geformt ist, daß bei geschlossenem Behälter die Flächenpressung über die Fläche der Dichtlippe (22) konstant ist.

3. Behälter nach Anspruch 1, **dadurch gekennzeichnet,** daß das Dichtungselement einen elastisch deformierbaren Dichtungsring (72) aufweist, der mit einem Streifen flexibler, abriebarmer Folie (71) so bedeckt ist, daß beim Öffnen und Schließen des Behälters der Dichtungsring (72) Zusammengepreßt wird, wobei keine Verunreinigungen durch von dem Dichtungsring (72) abgegebene Stoffe auftreten.

4. Behälter nach Anspruch 3, **dadurch gekennzeichnet,** daß der elastisch deformierbare Dichtungsring (72) in einer in der Bodenplatte (21) vorgesehenen Nut (74) geführt ist und der Folienstreifen (71) so über dem Dichtungsring (72) angeordnet und an der Bodenplatte (21) befestigt ist, daß er nicht gespannt ist, wobei ein hermetisch abgeschlossener luftgefüllter Hohlraum (75) gebildet wird, der beim Schließen des Behälters eine Druckerhöhung erfährt und durch Druckausgleich den Innendruck des Behälters erhöht.

5. Behälter nach einem der Ansprüche 3 oder 4, **dadurch gekennzeichnet,** daß der elastisch deformierbare Dichtungsring (72) ein eingeschäumtes Kunststoffteil mit einer Shorehärte im Bereich von 4-6° ist.

6. Behälter nach einem der Ansprüche 3 bis 5, **dadurch gekennzeichnet,** daß der Folienstreifen (71) eine Polyäthylenfolie mit einer Dicke von kleiner als 0,2 mm ist.

7. Behälter nach einem der Ansprüche 1 bis 6, **dadurch gekennzeichnet,** daß die Halbleiterscheibensicherung (31) eine den Halbleiterscheiben Zugewandte Sicherungsplatte (37) aufweist, die durch Filmgelenke (34,35) beweglich mit einer an der Innenwand der Haube (1) angebrachten Befestigungsplatte (39) und mit der Führungsplatte (38) über ein Filmgelenk (36) verbunden ist.

8. Behälter nach einem der Ansprüche 1 bis 7, **dadurch gekennzeichnet,** daß mindestens ein Behälterbestandteil Polypropylen enthält.

9. Behälter nach einem der Ansprüche 1 bis 7, **dadurch gekennzeichnet,** daß mindestens ein Behälterbestandteil Polykarbonat enthält.

10. Behälter nach einem der Ansprüche 1 bis 9, **dadurch gekennzeichnet,** daß die Halbleiterscheibensicherung (31) aus Polyäthylen besteht.

11. Behälter nach einem der Ansprüche 1 bis 10, **dadurch gekennzeichnet,** daß die Behälterbestandteile aus antistatischem kunststoff bestehen.

## Claims

1. Closable container for transporting and storing semiconductor wafers which are in a processing cassette disposed in the container, having a base plate, a hood and at least two closure levers for the nonpositive closure of the hood and the base plate, characterized by
a) a sealing element (22, 72) which is intended for the airtight sealing of the container and is provided circumferentially between the hood (1) and the base plate (21), and
b) a semiconductor wafer lock (31) which can be moved by means of film hinges (34, 35, 36) of thin material strips and which is attached to the internal wall of the hood (1) and is in contact with the base plate (21) via a guide plate (38) in such a way that, on closing the container, the lock is moved by the base plate (21) into a predetermined locking position in which the semiconductor wafer lock does not touch the semiconductor wafers.

2. Container according to Claim 1, characterized in that the sealing element is a surface-sealing sealing lip (22) which is permanently joined to the base plate (21) and the hood (1) has a sealing surface (9) which falls away inwards, the sealing lip (22) being shaped in such a way that, when the container is closed, the surface pressure is constant over the surface of the sealing lip (22).

3. Container according to Claim 1, characterized in that the sealing element has an elastically deformable sealing ring (72) which is covered with a strip of flexible, low-abrasion film (71) in such a way that, when the container is opened and closed, the sealing ring (72) is compressed and no contamination can occur as a result of substances given off by the sealing ring (72).

4. Container according to Claim 3, characterized in that the elastically deformable sealing ring (72) is guided in a groove (74) provided in the base plate (21) and the film strip (71) is disposed on top of the sealing ring (72) and attached to the base plate (21) in such a way that it is not stretched, a hermetically sealed, air-filled cavity (75) which undergoes an increase in pressure when the container is closed and increases the internal pressure of the container by pressure equalization being formed.

5. Container according to either of Claims 3 or 4, characterized in that the elastically deformable sealing ring (72) is a foamed plastic part having a Shore hardness in the region of 4-6°.

6. Container according to one of Claims 3 to 5, characterized in that the film strip (71) is a polyethylene film having a thickness of less than 0.2 mm.

7. Container according to one of Claims 1 to 6, characterized in that the semiconductor wafer lock (31) has a locking plate (37) which is adjacent to the semiconductor wafers and which is joined movably by means of film hinges (34, 35) to a fixing plate (39) mounted on the internal wall of the hood (1) and via a film hinge (36) to the guide plate (38).

8. Container according to one of Claims 1 to 7, characterized in that at least one container component contains polypropylene.

9. Container according to one of Claims 1 to 7, characterized in that at least one container component contains polycarbonate.

10. Container according to one of Claims 1 to 9, characterized in that the semiconductor wafer lock (31) comprises polyethylene.

11. Container according to one of Claims 1 to 10, characterized in that the container components comprise antistatic plastic.

## Revendications

1. Récipient pouvant être fermé pour le transport et le stockage de plaquettes semiconductrices qui sont situées dans une cassette de traitement disposée dans le récipient, et comportant une plaque de fond, un capot et au moins deux leviers de fermeture servant à fermer, selon une liaison de force, le capot sur la plaque de fond, caractérisé par
a) un élément d'étanchéité (22, 72) servant à fermer d'une manière étanche à l'air le récipient et qui est prévu selon une disposition circonférentielle entre le capot (1) et la plaque de fond (21), et
b) un dispositif (31) de fixation des plaquettes semiconductrices, qui est mobile grâce à la présence d'articulations en forme de pellicules (34, 35, 36) formées de bandes de matériau mince et qui est fixée à la paroi intérieure du capot (1) et est en contact, par l'intermédiaire d'une plaque de guidage (38), avec la plaque de fond (21) de sorte que, lors de la fermeture du récipient par la plaque de fond (21), elle est amenée dans une position de fixation prédéterminée dans laquelle le dispositif de fixation des plaquettes semiconductrices ne touche pas les plaquettes semiconductrices.

2. Récipient suivant la revendication 1, caractérisé par le fait que l'élément d'étanchéité est une lèvre d'étanchéité (22) qui est reliée de façon fixe à la plaque de fond (21) et établit une étanchéité sur une certaine surface et que le capot (1) possède une surface d'étanchéité (9) qui retombe vers l'intérieur, la lèvre d'étanchéité (22) étant conformée de telle sorte que, lorsque le récipient est fermé, la pression superficielle apppliquée sur la surface de la lèvre d'étanchéité (22) est constante.

3. Récipient suivant la revendication 1, caractérisé par le fait que l'élément d'étanchéité possède une bague d'étanchéité (12) déformable élastiquement, qui est recouverte par une bande formée d'une feuille flexible (71) résistante à l'usure de sorte que, lors de l'ouverture et de la fermeture du récipient, la bague d'étanchéité (72) est comprimée, auquel cas il ne se produit aucun salissement dû à des substances délivrée par la bague d'étanchéité (72).

4. Récipient suivant la revendication 3, caractérisé par le fait que la bague d'étanchéité déformable élastiquement (72) est guidée dans une rainure (74) ménagée dans la plaque de fond (21), et que la bande en forme de feuille (71) est disposée au-dessus de la bague d'étanchéité (72) et est fixée à la plaque de base (21) de sorte qu'elle n'est pas serrée, et il se forme une cavité (75) remplie d'air et fermée de façon hermétique et qui, lors de la fermeture du récipient, est le siège d'un accroissement de pression et, par compensation de pression, accroît la pression intérieure du récipient.

5. Récipient suivant l'une des revendications 3 ou 4, caractérisé par le fait que la bague d'étanchéité déformable élastiquement (72) est une pièce en matière plastique à l'état de mousse possédant une dureté Shore dans la gamme de 4-6°.

6. Récipient suivant l'une des revendications 3 à 5, caractérisé par le fait que la bande en forme de feuille (71) est une feuille de polyéthylène possédant une épaisseur inférieure à 0,2 mm.

7. Récipient suivant l'une des revendications 1 à 6, caractérisé par le fait que le dispositif (31) de fixation des plaquettes semiconductrices possède une plaque de fixation (37), qui est tournée vers les plaquettes semiconductrices et qui est reliée, avec une possibilité de déplacement grâce à des articulations en forme de pellicules (34, 35), à une plaque de fixation (39) montée sur la paroi intérieure du capot (1) et à la plaque de guidage (38) par l'intermédiaire d'une articulation en forme de pellicule (36).

8. Récipient suivant l'une des revendications 1 à 7, caractérisé par le fait qu'au moins un composant du récipient contient du polypropylène.

9. Récipient suivant l'une des revendications 1 à 7, caractérisé par le fait qu'au moins un composant du récipient contient du polycarbonate.

10. Récipient suivant l'une des revendications 1 à 9, caractérisé par le fait que le dispositif (31) de fixation des plaquettes semiconductrices est réalisé en polyéthylène.

11. Récipient suivant l'une des revendications 1 à 10, caractérisé par le fait que les composants du récipient sont formés par une matière plastique antistatique.
